# EUROPEAN PATENT SPECIFICATION

(11) **EP 1 947 673 B1**
(45) Date of publication and mention of the grant of the patent: **23.05.2012**
(21) Application number: 07104390.5
(22) Date of filing: 19.03.2007
(51) Int. Cl.: C23C 14/08, C23C 14/34, H01J 9/02, H01J 29/08, C04B 35/453

(54) **Method of manufacturing an indium tin oxide target**
Verfahren zur Herstellung eines Indiumzinnoxid-Targets
Procédé de fabrication d'une cible d'oxyde d'étain indium

(30) Priority: 22.01.2007 KR 20070006726
(43) Date of publication of application: 23.07.2008
(73) Proprietor: Samsung Corning Precision Materials Co., Ltd., Gumi-si Gyeongsangbuk-do 730-360 (KR)
(72) Inventor: Jeong, Joon-Hee, 1-dong, Suji-gu, Yongin-si Kyungki-do 448-767 (KR); Choi, Jun Ho, Gwonseon-gu, Suwon-si Kyungki-do 441-742 (KR); Lee, Sangchul, Buk-gu Daegu 702-757 (KR); Kang, Shinhyuk, Jangan-gu, Suwon-si Kyungki-do 440-727 (KR)
(74) Representative: Rupprecht, Kay

(56) References cited:
- JP-A- 9 110 527
- US-A- 5 433 901
- US-A- 5 980 815
- MURAOKA M ET AL: "SINTERING OF TIN-DOPED INDIUM OXIDE (INDIUM-TIN-OXIDE, ITO) WITH BI2O3 ADDITIVE" JOURNAL OF MATERIALS SCIENCE, SPRINGER / BUSINESS MEDIA, DORDRECHT, NL, vol. 33, no. 23, 1 December 1998 (1998-12-01), pages 5621-5624, XP000803592 ISSN: 0022-2461
- SUZUKI M ET AL: "ITO films sputter-deposited using an ITO target sintered with vanadium oxide additive" MATERIALS SCIENCE AND ENGINEERING B, ELSEVIER SEQUOIA, LAUSANNE, CH, vol. 54, no. 1-2, 12 June 1998 (1998-06-12), pages 43-45, XP004147246 ISSN: 0921-5107

## Description

### BACKGROUND OF THE INVENTION

### 1. Field of the Invention

The present invention relates to a method of manufacturing an indium tin oxide (ITO) target, and more particularly, to a a method of manufacturing the ITO target with high density required for vacuum deposition of a high-quality transparent electrode layer in a display device such as a liquid crystal display (LCD), an organic light emitting diode (OLED), a plasma display panel (PDP) device, and the like.

### 2. Description of Related Art

An indium tin oxide (ITO) film including ITO is generally used for a transparent thin film electrode in a display apparatus such as a liquid crystal display (LCD), an organic light emitting diode (OLED), a plasma display panel (PDP), a field emission display (FED), and the like due to superior characteristics such as high conductivity, high transmittance with respect to visible light, and the like. The ITO transparent film electrode may be formed by chemical vapor deposition (CVD), atomic layer deposition (ALD), sputtering, and the like, however, the sputtering is widely used due to ease in forming a thin film, easy application to a substrate having a large surface, and the like. In the sputtering, when argon plasma is formed using a target including a component of an objective film, providing gas such as argon and the like in a vacuum, and generating a discharge between a substrate corresponding to an anode, and a target corresponding to a cathode, particles in the target are dropped while an argon cation collides with a target corresponding to a cathode, and are accumulated on the substrate, and a film is grown.

JP 9-110 527 A discloses a method to produce a high density, ITO sintered compact intended for sputtering targets. The sintered compact density is improved by adding calcium and carbon. CaO is used as additive, calcium carbonate is mentioned as alternative.

The sputtering includes a method of using high frequency plasma, and a method of using direct current (DC) plasma depending on a method of forming argon plasma. The method of using the DC plasma is generally used due to a high growing speed of a film, and convenient operation.

The sputtering using the DC plasma has a problem that an arc is generated while growing a film, or a nodule is generated on a target surface, so that an extraneous material is mixed in a thin film, and a speed of growing a film is reduced. In particular, a number of the arcs and the nodules significantly increases over the course of time of growing a film, therefore, a target may not be used for a relatively long period of time. BRIEF SUMMARY

The present invention provides a method of manufacturing an indium tin oxide (ITO) target with high density which can reduce a number of arcs and nodules being generated while growing a transparent conductive thin film by sputtering, thereby growing the film at a high speed and enabling the film to be used for a long period of time. There is provided an ITO transparent electrode for a display apparatus manufactured from an ITO target.

According to an aspect, there is provided an ITO target including calcium of about 0.001% to about 10% by atom, compared with an indium atom. In the ITO target, fewer than about 500 arcs are generated during sputtering when a period of time of growing an ITO thin film corresponds to about 30 hours, and a relative density of the ITO target is greater than or equal to 99%.

According to another aspect, there is provided an ITO transparent electrode for a display apparatus manufactured from an ITO target including calcium of about 0.001% to about 10% by atom, compared with an indium atom.

According to the present invention, there is provided a method of manufacturing an ITO target, the method including: preparing a slurry by mixing indium oxide powder, tin oxide powder, and calcium carbonate powder; granulating the slurry by milling and drying the slurry to prepare a granulated powder; shaping the granulated powder to form a shaped body; and sintering the shaped body.

The average diameter of the calcium carbonate powder corresponds to 0.1 µm to 2 µm. Also, the calcium carbonate powder is added so that a ratio of calcium corresponds to 0.001% to 0.3% by atom, compared with an indium atom.

Preferably, the average diameter of the indium oxide powder corresponds to 0.1 µm to 1 µm, and the average diameter of the tin oxide powder corresponds to 1 µm to 5 µm. The mass ratio of the indium oxide powder and the tin oxide powder corresponds to 90:10 to 91:9.

In the preparation of the slurry, at least one compound selected from the group consisting of polyvinyl alcohol (PVA), polyethylene glycol (PEG), a dispersing agent, and an antifoaming agent may be added, and the sintering of the shaped body is performed under an oxide atmosphere and an air atmosphere in a temperature corresponding to 1400°C to 1600°C.

### BRIEF DESCRIPTION OF THE DRAWINGS

The above and/or other aspects and advantages of the present invention will become apparent and more readily appreciated from the following detailed description, taken in conjunction with the accompanying drawings of which:
FIG. 1 is a graph illustrating a number of times arcs are generated over time according to Exemplary embodiment 1 and Comparative example 1;
FIGS. 2 and 3 are surface pictures of an indium tin oxide (ITO) target manufactured according to Exemplary embodiment 1 after the target is respectively sputtered during 18 hours and 30 hours; and
FIGS. 4 and 5 are surface pictures of an ITO target manufactured according to Comparative example 1 after the target is respectively sputtered during 18 hours and 30 hours.

### DETAILED DESCRIPTION OF EMBODIMENTS

Reference will now be made in detail to exemplary embodiments of the present invention, examples of which are illustrated in the accompanying drawings, wherein like reference numerals refer to the like elements throughout. The exemplary embodiments are described below in order to explain the present invention by referring to the figures.

Hereinafter, a method of manufacturing an indium tin oxide (ITO) target according to the present invention is described in detail.

A method of manufacturing an ITO target according to the present invention includes preparing a slurry, granulating the slurry by milling and drying the slurry to prepare a granulated powder, shaping the granulated powder to form a shaped body; and sintering the shaped body.

The slurry is prepared by providing an appropriate amount of water in a container, and mixing an indium oxide (In₂O₃) powder, a tin oxide (SnO₂) powder, and a calcium-containing compound powder in the container. The In₂O₃ powder, the SnO₂ powder, and the calcium-containing compound powder may be respectively pulverized to have a particle size less than or equal to a diameter of a couple of micrometers before being mixed.

The calcium-containing compound powder is calcium carbonate (CaCO₃). Since CaCO₃ is convenient to deal with, and may be easily obtained, CaCO₃ from among calcium-containing compounds is most desirable.

The average diameter of the calcium carbonate powder corresponds to 0.1 µm to 2 µm. It is desirable that the average diameter corresponds to 0.1 µm to 1 µm. When the diameter of the calcium carbonate powder is small, solid solubility with In₂O₃ and SnO₂ is increased. Accordingly, it is desirable that the diameter is controlled to be less than or equal to 1 µm.

In the present invention, the calcium carbonate powder is added so that a ratio of calcium corresponds to about 0.001% to about 0.3% by atom, compared with an indium atom. When the content of calcium is less than 0.001% by atom, an effect of reducing arcs and nodules is decreased. Conversely, when the content of calcium is higher than 10% by atom, resistance of a thin film formed by sputtering is increased, and the thin film is inappropriate for being used for a transparent conductive film of an LCD, and the like.

The average diameter of the indium oxide powder corresponds to 0.1 µm to 1 µm, and the average diameter of the tin oxide powder corresponds to 1 µm to 5 µm. Also, the mass ratio of the indium oxide powder and the tin oxide powder corresponds to 90:10 to 91:9, and it is desirable that the mass ratio of the indium oxide powder and the tin oxide powder corresponds to 90:10 to 90.2:9.8.

An additional agent may be inputted in the slurry as necessary during mixing the indium oxide powder, the tin oxide powder, and the calcium-containing compound powder. The additional agent according to an exemplary embodiment of the present invention is at least one compound selected from the group consisting of a binder, a dispersing agent, and an antifoaming agent.

The dispersing agent is added so that a pulverized material particle may maintain even, stable dispersion during a long period of time in solution, and the particle may be finely pulverized. Organic acid series including a carboxyl group such as citric acid (CA), polyacrylic acid (PAA), salt thereof, copolymer, and the like are used for the dispersing agent. The dispersing agent may be used alone or in a combination of at least two dispersing agents.

The binder is added in order to maintain shaping strength of a shaped body during shaping of the granulated powder after drying the slurry in the powders, and a polymer such as polyvinyl alcohol (PVA), polyethylene glycol (PEG), and the like may be used for the binder. The polymer may be used alone or in a combination of at least two polymers. An added amount of the binder may correspond to about 0.01% to about 5% by weight, compared with the powders in the slurry, and it is desirable that the added amount may correspond to about 0.5% to about 3% by weight.

The antifoaming agent is intended to remove foams in the slurry, and silicone oil, octyl alcohol, sodium sulfate, and the like may be generally used for the antifoaming agent. However, the present invention is not limited thereto.

Next, the granulating of the slurry and the shaping of the granulated powder are described.

In the preparation of the slurry, granulated powder is prepared by milling and drying the slurry prepared by mixing the indium oxide powder, the tin oxide powder, the calcium carbonate powder, water, and the additional agent. When the slurry is milled, a ball mill, a bead mill, and the like may be used, and a wet milling method is generally used. However, the present invention is not limited thereto. It is desirable that the viscosity of the slurry obtained by milling is less than or equal to 0.1 Pa·s (100 cps). When the viscosity is higher than 0.1 Pa·s (100 cps), the particle size in the slurry is large, and the dispersibility is reduced. Therefore, the density of the sintered body is reduced after sintering the shaped body.

The granulated powder is obtained by milling and spray-drying the slurry using a spray dryer and the like. Next, shaping the granulated powder to form a shaped body in a uniform shape is performed. A cold isostatic press (CIP), and the like, is used, and it is desirable that the CIP process is used considering convenience of the process when the shaped body is manufactured.

The ITO target is manufactured by sintering the shaped body after shaping the granulated powder. The sintering may be performed under an oxide atmosphere, a combination atmosphere of air and oxide, and an air atmosphere at a temperature corresponding to 1400°C to 1600°C. It is desirable that the sintering is performed under the oxide atmosphere at a temperature corresponding to 1500°C to 1600°C. The sintering temperature range is related to the density of the sintered body, and when the sintering is performed in a temperature corresponding to 1400°C to 1600°C, the density of the ITO sintered body is greater than or equal to 99%, and it is desirable that the density is greater than or equal to 99.5%.

The sintered body is processed in a uniform size and a uniform form, is attached to a backing plate, and is used as a sputtering target. An ITO transparent electrode may be manufactured in an atmosphere of argon gas, which includes oxygen of 0.1%, with a vacuum vessel at a speed 80 seem, and growing a film.

Hereinafter, a method of manufacturing the ITO target according to exemplary embodiments of the present invention is described in detail. The exemplary embodiments are provided to describe the method more specifically. However, the present invention is not limited to the exemplary embodiments disclosed below.

### [Exemplary embodiment 1]

A slurry is prepared by mixing about 1804 g of indium oxide powder, about 196 g of tin oxide powder, and about 1g of calcium carbonate powder with about 1 l of water. The indium oxide powder has a degree of purity of about 99.99%, and an average diameter about 0.7 µm, and the tin oxide powder has a degree of purity of about 99.9%, and an average diameter of about 3 µm. Also, the calcium carbonate powder has a degree of purity of about 99.99%, and an average diameter of about 1 µm. About 220 g of PVA diluted to about 10% by weight, about 8 g of PEG, about 34.2 g of a dispersing agent, and about 0.07 g of an antifoaming agent are added to the slurry.

A granulated powder is obtained milling the slurry with a ball mill for 20 minutes, and spray-drying the slurry with a spray dryer. The granulated powder is shaped to form the shaped body performing a CIP process after one axis pressure shaping with about 18 ton/cm² of pressure in order to have a diameter of about 7.6 cm (3 in), and in order to have a thickness of about 1 cm.

An ITO sintered body is obtained sintering the shaped body under an oxide atmosphere in a temperature about 1550°C for 6 hours. Also, an ITO target is manufactured processing the sintered body having a diameter of about 7.6 cm (3 in) and a thickness of about 7 mm, and melting and joining an indium metal in a backing plate including copper. The density of the ITO target corresponds to a relative density of about 99.63% compared with the theoretical density of about 7.152 g/cm³.

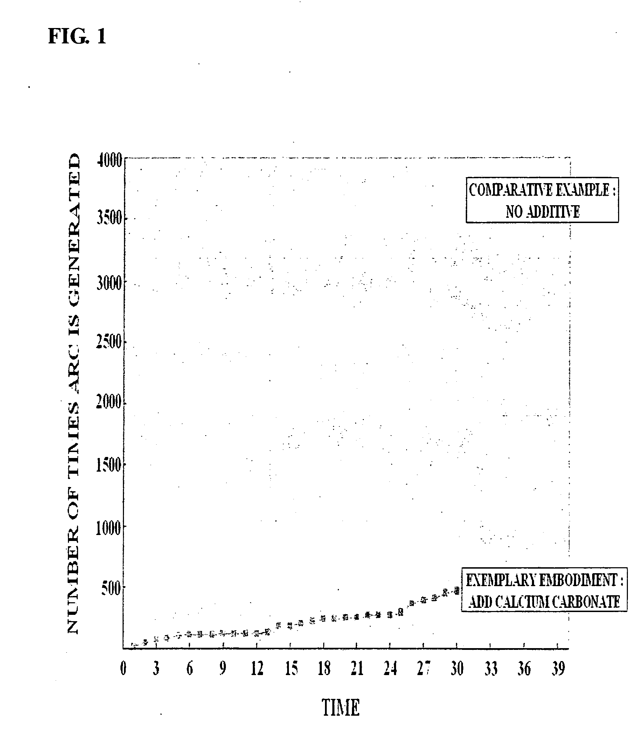

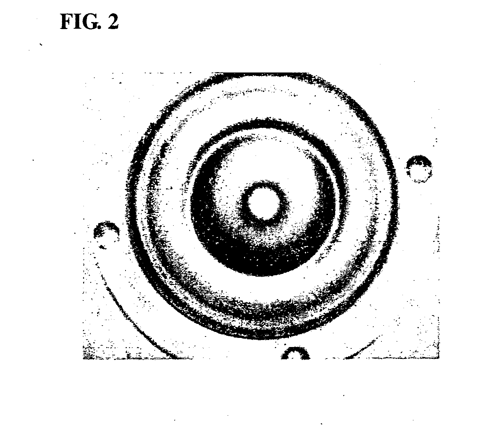

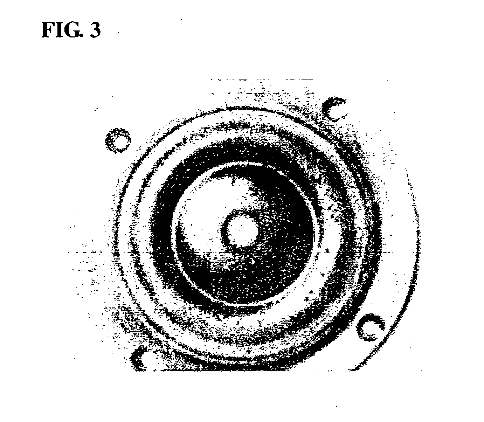

The ITO target is installed in a direct current (DC) magnetron sputtering apparatus where a high-degree vacuum is maintained, and argon gas including about 0.1% of oxygen is provided at a speed of about 80 seem. A number of times arcs are generated every hour is measured using an arc counter when growing a film with an input power of about 100 W for 30 hours. Also, nodules of the target surface are observed after 18 hours and 30 hours. The number of times arcs are generated when growing a film is illustrated in FIG. 1, and pictures of a target surface after 18 hours and 30 hours are respectively illustrated in FIGS. 2 and 3.

As a result, about only 472 arcs are generated after growing a film for 30 hours, and generated nodules are also few, as illustrated in FIGS. 2 and 3.

### [Comparative example 1]

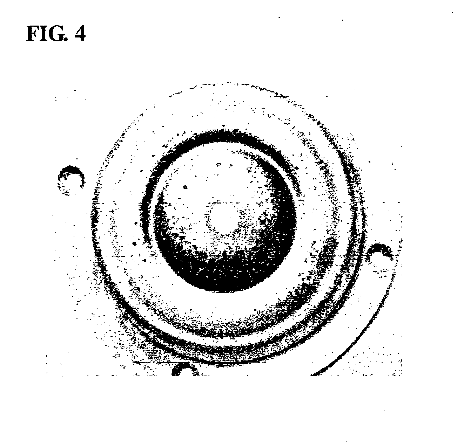

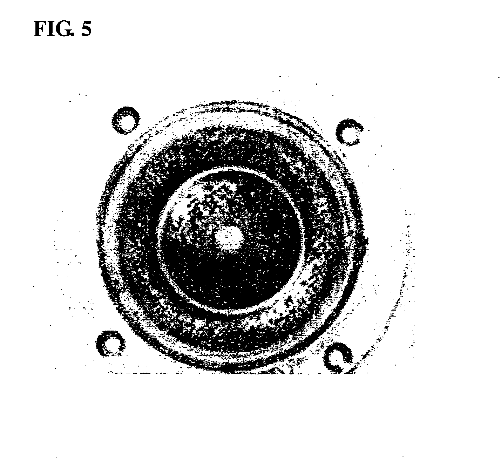

An ITO target is manufactured, excluding calcium carbonate powder, and a residual process is performed similar to Exemplary embodiment 1 described above. The density of the ITO target shows a relative density of about 99.66%, compared with the theoretical density of about 7.152g/cm³, and the density of the ITO target is similar to Exemplary embodiment 1. Also, a number of times arcs are generated every hour by DC magnetron sputtering is illustrated in FIG. 1, and pictures of the target surface after growing a film for 18 hours and for 30 hours are respectively illustrated in FIGS. 4 and 5.

As a result, about 3641 arcs are generated after growing the film for 30 hours, corresponding to more than about seven times the number of arcs generated when the target calcium carbonate is added. Also, more nodules are generated compared with the number of nodules generated in Exemplary embodiment 1, as illustrated in FIGS. 4 and 5.

Hereinafter, an ITO target and an ITO transparent electrode for a display apparatus are described.

The ITO target manufactured by the method of manufacturing the ITO target according to the present invention includes calcium of 0.001% to 0.3% by atom, compared with an indium atom. A number of times arcs and nodules are generated is significantly reduced by using calcium during sputtering. When a content of calcium is less than 0.001% by atom, an effect of reducing arcs and nodules is decreased, and when the content is greater than 10% by atom, resistance of a thin film formed by the sputtering is increased and the thin film is inappropriate for a transparent conductive film.

In the ITO target including calcium, around 500 or fewer arcs are generated during sputtering when growing the ITO thin film for 30 hours, which is about 20% of generated arcs of the ITO target excluding calcium. Also, the relative density of the ITO target is greater than or equal to 99%, compared with a theoretical density 7.152g/cm³ of the ITO target.

The ITO transparent electrode for the display apparatus includes calcium of 0.001% to 0.3% by atom, compared with an indium atom. The ITO transparent electrode has a specific resistance of about 2×10⁻⁴Ω·cm and high transmittance with respect to visible light.

According to the present invention, ITO include a small amount of calcium, thereby reducing a number of times arcs and nodules are generated, compared with an existing ITO target, and growing a film at a high speed. Also, sputtering for a long period of time can be performed with the ITO target including calcium, thereby improving efficiency of manufacturing process. Also, the density of the ITO target including calcium is similar to the existing ITO target, and the ITO transparent electrode manufactured from the ITO target can have a characteristic that a specific resistance or a transmittance with respect to visible light is great.

Although a few exemplary embodiments of the present invention have been shown and described, the present invention is not limited to the described exemplary embodiments. Instead, it would be appreciated by those skilled in the art that changes may be made to these exemplary embodiments without departing from the invention, the scope of which is defined by the claims.

## Claims

1. A method of manufacturing an indium tin oxide (ITO) target, the method comprising the steps of:
- preparing a slurry by mixing an indium oxide powder and a tin oxide powder;
- granulating the slurry by milling and drying the slurry to prepare a granulated powder;
- shaping the granulated powder to form a shaped body; and
- sintering the shaped body;
**characterized in that**
a calcium carbonate powder is mixed with the indium oxide powder and the tin oxide powder when preparing the slurry, wherein a mass ratio of the indium oxide powder to the tin oxide powder corresponds to 90:10 to 91:9 and the calcium carbonate powder is added so that a ratio of calcium corresponds to 0.001% to 0.3% by atom, compared with an indium atom, wherein an average diameter of the calcium carbonate powder corresponds to 0.1 µm to 2 µm, and
wherein the relative density of the ITO target is greater than or equal to 99 %.

2. The method of claim 1,
wherein an average diameter of the indium oxide powder corresponds to 0.1 µm to 1 µm, and an average diameter of the tin oxide powder corresponds to 1 µm to 5 µm.

3. The method of claim 1,
wherein the sintering is performed under an oxide atmosphere and an air atmosphere at a temperature corresponding to 1400°C to 1600°C.

## Patentansprüche

1. Verfahren zur Herstellung eines Indiumzinnoxid- (ITO)-Target, wobei das Verfahren die Schritte aufweist:
- Herstellen eines feinen Schlamms durch Mischen eines Indiumoxidpulvers und eines Zinnoxidpulvers;
- Granulieren des Schlamms durch Mahlen und Trocknen des Schlamms, um ein Granulatpulver herzustellen;
- Formen des Granulatpulvers, um einen geformten Körper auszubilden; und
- Sintern des geformten Körpers,
**dadurch gekennzeichnet, dass**
beim Herstellen des feinen Schlamms ein Kalziumcarbonatpulver mit dem Indiumoxidpulver und dem Zinnoxidpulver gemischt wird, wobei das Massenverhältnis des Indiumoxidpulvers zum Zinnoxidpulver 90 : 10 bis 91 : 9 beträgt, und das Kalziumcarbonatpulver zugefügt wird, so dass das Kalziumverhältnis 0,001 bis 0,3 Atomprozent im Vergleich zu einem Indiumatom beträgt, wobei der durchschnittliche Durchmesser des Kalziumcarbonatpulvers 0,1 µm bis 2 µm beträgt, und
wobei die relative Dichte des ITO-Target größer als oder gleich 99% ist.

2. Verfahren nach Anspruch 1,
bei dem der durchschnittliche Durchmesser des Indiumoxidpulvers 0,1 µm bis 1 µm und der durchschnittliche Durchmesser des Zinnoxidpulvers 1 µm bis 5 µm beträgt.

3. Verfahren nach Anspruch 1,
bei dem das Sintern in einer Oxidatmosphäre und einer Luftatmosphäre bei einer Temperatur von 1400°C bis 1600°C ausgeführt wird.

## Revendications

1. Procédé de fabrication d'une cible en oxyde indium-étain (ITO), le procédé comprenant les étapes consistant à :
- préparer une boue en mélangeant une poudre d'oxyde d'indium et une poudre d'oxyde d'étain ;
- mettre la boue en granulés en broyant et en séchant la boue pour préparer une poudre granulée ;
- conformer la poudre granulée pour former un corps conformé ; et
- fritter le corps conformé ;
**caractérisé en ce que**
une poudre de carbonate de calcium est mélangée avec la poudre d'oxyde d'indium et la poudre d'oxyde d'étain lorsqu'on prépare la boue, de sorte qu'un rapport de masse de la poudre d'oxyde d'indium sur la poudre d'oxyde d'étain correspond à 90:10 à 91:9, et on ajoute la poudre de carbonate de calcium de telle façon qu'un rapport de calcium corresponde à 0,001 % à 0,3 atomes %, comparé à un atome d'indium,
dans lequel le diamètre le moyen de la poudre de carbonate de calcium correspond à 0,1 µm à 2 µm, et
dans lequel la densité relative de la cible en ITO est supérieure ou égale à 99 %.

2. Procédé selon la revendication 1,
dans lequel un diamètre moyen de la poudre d'oxyde d'indium correspond à 0,1 µm à 1 µm, et un diamètre moyen de la poudre d'oxyde d'étain correspond à 1 µm à 5 µm.

3. Procédé selon la revendication 1,
dans lequel le frittage est exécuté sous une atmosphère d'oxyde et une atmosphère d'air à une température correspondant à 1400° C à 1600° C.
